# EUROPEAN PATENT APPLICATION

(11) **EP 3 528 067 A1**
(43) Date of publication of application: **21.08.2019**
(21) Application number: 17860480.7
(22) Date of filing: 19.09.2017
(51) Int. Cl.: G05B 19/05, H04L 12/28

(54) **COMPUTING DEVICE AND CONTROL SYSTEM**

(30) Priority: 14.10.2016 JP 2016202216
(71) Applicant: Omron Corporation, Kyoto-shi, Kyoto 600-8530 (JP)
(72) Inventor: FUKUDA, Yasunori, Kyoto-shi Kyoto 600-8530 (JP); EGUCHI, Shigeyuki, Kyoto-shi Kyoto 600-8530 (JP)
(74) Representative: Emde, Eric
(86) International application number: PCT/JP2017/033635
(87) International publication number: WO 2018/070190

(57) **Abstract**

Provided is a computing device constituting a control system. The computing device includes: a master clock that manages the time for the control system; a first communication circuit that transmits and receives data to and from a first functional unit, via a first communication line; a second communication circuit that transmits and receives data to and from a second functional unit, via a second communication line; and a timing instruction unit for instructing the first functional unit regarding a first timing at which to start processing for outputting a signal corresponding to output data received by the first functional unit, and also instructing the second functional unit regarding a second timing at which to start processing for outputting a signal corresponding to output data received by the second functional unit.

## Description

### Technical Field

The present invention relates to a control system including a plurality of functional units and a computing unit constituting the control system.

### Background Art

As a main component for realizing a variety of factory automation (FA), a control device such as a programmable controller (PLC) is commonly used. Such a control device exchanges data with one or a plurality of functional units via a communication line.

When a plurality of functional units is connected via communication lines, a delay occurs due to data transfer on the communication line. A magnitude of such a delay varies depending on a position at which the functional unit is connected. Timings at which the functional unit acquires input data and outputs output data may vary depending on such a variation in the delay time.

To solve such a problem, Japan Patent Application Publication No. 2014-120884 (Patent Document 1) discloses an environment in which a synchronization timing in a control system may be determined, where the control system includes a master device and one or a plurality of slave devices connected via a network.

### Summary

### [Technical Problem]

The control system disclosed in Japan Patent Application Publication No. 2014-120884 is a system that considers synchronization between functional units connected to a master device and a slave device connected to the master device via a network, in which a method of performing synchronization between a functional unit connected to an internal bus of a PLC that is a master device and a functional unit connected to the slave device is not disclosed.

An object of the present invention is to provide a novel configuration capable of synchronizing timings at which respective signals are output between a plurality of functional units connected to a computing device via different communication lines.

### [Solution to Problem]

According to an aspect of the present invention, a computing device constituting a control system is provided. A computing device includes a master clock that manages a time in the control system, and a first communication circuit that transmits and receives data to and from a first functional unit via a first communication line. The first functional unit includes a first clock synchronized with the master clock. The computing device includes a second communication circuit that transmits and receives data to and from a second functional unit via a second communication line. The second functional unit includes a second clock synchronized with the master clock. The computing device includes a timing instructing unit that instructs, to the first functional unit, a first timing at the time when a process of outputting a signal corresponding to output data received in the first functional unit is to be started, and instructs, to the second functional unit, a second timing at the time when a process of outputting a signal corresponding to output data received in the second functional unit is to be started. The first and second timings are defined with reference to the time that is managed by the master clock.

Preferably, the computing device further includes a calculation unit that calculates a first delay time and a second delay time. The first delay time is a time required until a signal corresponding to output data becomes able to be output in the first functional unit after transmission of the output data to the first communication circuit is requested. The second delay time is a time required until a signal corresponding to output data becomes able to be output in the second functional unit after transmission of the output data to the second communication circuit is requested.

Preferably, the computing device further includes a synchronization timing determination unit that determines a synchronization timing at which a functional unit included in the control system outputs a signal on the basis of a maximum value of the first delay time and a maximum value of the second delay time. The synchronization timing determination unit determines the first and second timings on the basis of the determined synchronization timing.

Preferably, the calculation unit calculates the first delay time and the second delay time in consideration of at least some of (1) a time required until data is transmitted onto the first communication line after transmission of output data to the first communication circuit is requested, (2) a time required until data is transmitted onto the second communication line after transmission of output data to the second communication circuit is requested, (3) a time required until the data transmitted onto the first communication line is transferred to the first functional unit, (4) a time required until the data transmitted onto the second communication line is transferred to the second functional unit, (5) a time required until a signal corresponding to received data becomes able to be output after the first functional unit receives the output data, and (6) a time required until a signal corresponding to received data becomes able to be output after the second functional unit receives the output data.

Preferably, the timing instructing unit acquires the first timing and the second timing from an external device connected to the computing device.

Preferably, the computing device further includes a processor that executes a program; and a communication activation circuit that is connected to the processor and requests transmission of output data to the first communication circuit and the second communication circuit.

Preferably, the communication activation circuit is implemented using an field-programmable gate array (FPGA) or an application specific integrated circuit (ASIC).

A control system according to another aspect of the present invention includes a computing device including a master clock that manages a time in the control system; and a first functional unit that is connected to the computing device via a first communication line. The first functional unit includes a first clock synchronized with the master clock. The control system includes a relay device that is connected to the computing device via a second communication line; and a second functional unit that is connected to the relay device via a third communication line. The second functional unit includes a second clock synchronized with the master clock. The computing device includes a timing instructing unit that instructs, to the first functional unit, a first timing at which a process of outputting a signal corresponding to output data received in the first functional unit is to be started, and instructs, to the second functional unit, a second timing at which a process of outputting a signal corresponding to output data received in the second functional unit is to be started. The first and second timings are defined with reference to the time that is managed by the master clock.

### [Advantageous Effects of Invention]

According to the present invention, it is possible to synchronize timings at which respective signals are output between a plurality of functional units connected to a computing device via different communication lines.

### [Brief Description of Drawings]

FIG. 1 is a schematic diagram illustrating an output timing synchronization function that is provided by a control system according to this embodiment.
FIG. 2 is a schematic diagram illustrating a main configuration of a control system according to the embodiment.
FIG. 3 is a diagram illustrating a process necessary for starting to output or updating an output signal in the control system according to the embodiment.
FIG. 4 is a schematic diagram illustrating an example of a data structure of an I/O refreshing frame that is used in the control system according to the embodiment.
FIG. 5 is a timing chart illustrating a process of each unit related to an output timing synchronization function that is provided by the control system according to the embodiment.
FIG. 6 is a diagram illustrating a calculation procedure of a maximum delay time related to an output timing synchronization function that is provided by the control system according to the embodiment.
FIG. 7 is a schematic diagram focusing on clocks disposed in a distributive manner in the control system according to the embodiment.
FIG. 8 is a schematic diagram illustrating a configuration example for setting an output synchronization timing in the control system according to the embodiment.
FIG. 9 is a flowchart illustrating a processing procedure related to the output timing synchronization function in the control system according to the embodiment.

### [Description of Embodiments]

Embodiments of the present invention will be described in detail with reference to the drawings. It should be noted that, in the drawings, the same or corresponding parts are denoted by the same reference numerals, and description thereof will not be repeated.

In the following description, a programmable controller (PLC) will be described as a specific example of a "control device", but the present invention is not limited to the name of a PLC and the technical spirit disclosed in the present specification can be applied to any control device. Further, the entire system including the PLC (a control device) is also hereinafter referred to as a "control system".

### <A. Overview>

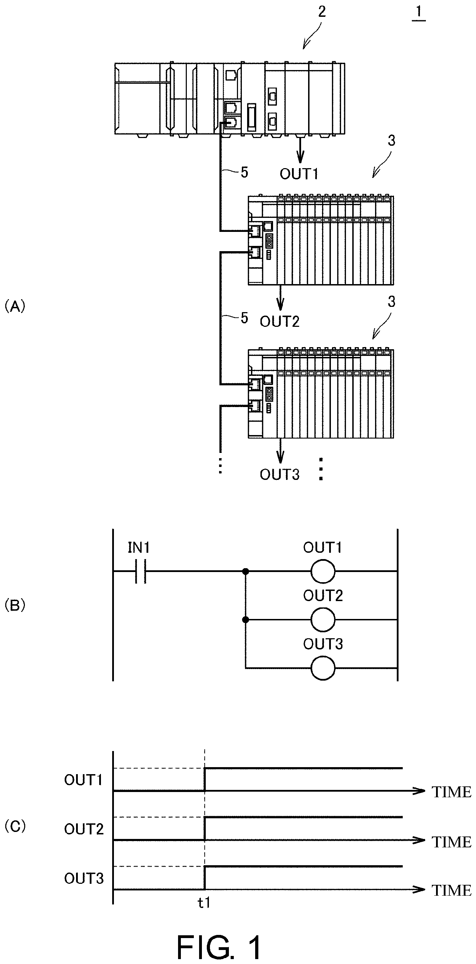

First, an output timing synchronization function that is provided by a control system according to the embodiment will be described. FIG. 1 is a schematic diagram illustrating an output timing synchronization function that is provided by a control system 1 according to the embodiment.

Referring to FIG. 1(A), the control system 1 includes, for example, a PLC 2, and one or a plurality of remote I/O devices 3. In the PLC 2, one or a plurality of functional units mounted in the PLC 2 are connected via an internal network (not illustrated) or an internal bus (not illustrated). In each of the remote I/O devices 3, one or a plurality of functional units mounted in the remote I/O device 3 are connected via a network (not illustrated) or a bus (not illustrated). The PLC 2 and the one or plurality of remote I/O devices 3 are connected to each other via a network.

Hereinafter, in each device of the PLC 2 or the remote I/O devices 3, a communication line (typically, an internal network or an internal bus) for exchanging data between the functional units mounted in each device is referred to as a "local network", and a communication line for exchanging data between the PLC 2 and the one or plurality of remote I/O devices 3 is referred to as a "remote network". The names "local network" and "remote network" are for convenience of description, and the technical scope of the present invention is not limited to these names. That is, in the present specification, "communication line" generally includes a framework for transmitting and receiving data between devices or units according to some protocol. The "communication line" may adopt either a parallel communication scheme or a serial communication scheme, and may be either a bus or a network.

In the present specification, the "functional units" include functional units that provide various functions necessary for realizing control of various machines and facilities in the control system. Examples of the functional units include an I/O unit, a communication unit, a temperature adjustment unit, and an identifier (ID) sensor unit.

The I/O unit may be, for example, a digital input (DI) unit, a digital output (DO) unit, an analog output (AI) unit, an analog output (AO) unit, a pulse catch input unit, and a composite unit in which units of a plurality of types are combined.

The temperature adjustment unit may include a control device including an analog input function for acquiring a temperature measurement value and the like, an analog output function for outputting a control command and the like, and a proportional integral differential (PID) control function. The ID sensor unit may include a device that reads out data from a Radio Frequency Identifier (RFID) or the like in a non-contact manner.

In the control system 1 illustrated in FIG. 1(A), an output signal OUT1 externally output from a functional unit mounted in the PLC 2, and output signals OUT2 and OUT3 externally output from the functional units respectively mounted in the two remote I/O devices 3 connected to the PLC 2 via the remote network 5 are considered. Values of the output signals OUT 1, OUT2, and OUT3 are values in which values of data supplied to the corresponding functional units (hereinafter also referred to as "output data") are reflected. That is, the output data corresponds to a command value defining a signal externally output from each functional unit 150 to a machine or facility that is a control target.

FIG. 1(B) illustrates an example of a user program that is executed by the PLC 2. The user program illustrated in FIG. 1(B) includes an instruction to activate three output signals OUT1, OUT2, and OUT3 in parallel by setting a signal (hereinafter also referred to as "input data") IN1 from a field or the like collected by an arbitrary functional unit as a condition.

A time chart of FIG. 1(C) illustrates an example of results of the output timing synchronization function with respect to the user program illustrated in FIG. 1(B). As illustrated in this time chart, values of the output signal OUT1 from the functional unit mounted in the PLC 2 and the output signals OUT2 and OUT3 from the respective functional units mounted in the remote I/O devices 3 all change from ON to OFF at the same timing t1.

Thus, the output timing synchronization function according to the embodiment provides a function of starting to output or updating a designated output signal at a designated timing all at once, regardless of positions of a plurality of functional units constituting the control system 1.

It should be noted that although a configuration in which the functional units are mounted in the remote I/O devices 3 connected via the remote network 5 is illustrated in FIG. 1, the present invention can also be applied to a configuration in which the individual functional units are directly mounted in the remote network 5. Further, another lower level network can be configured by adopting a communication unit as the functional unit. The output timing synchronization function can also be applied to functional units that are connected to the lower level network configured in this way.

### <B. Device configuration>

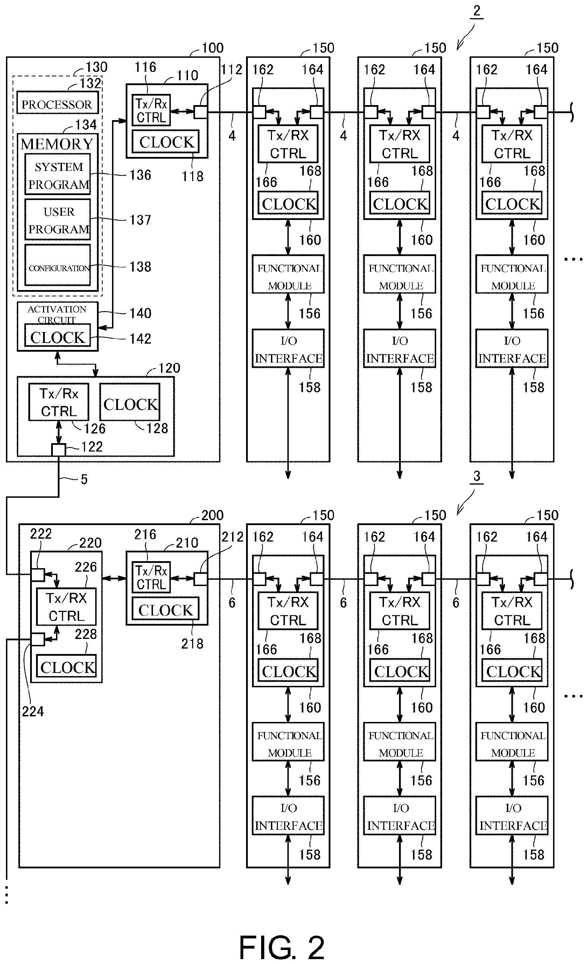

Next, a configuration of the control system 1 according to the embodiment will be described. FIG. 2 is a schematic diagram illustrating a main configuration of the control system 1 according to the embodiment.

Referring to FIG. 2, the PLC 2 according to the embodiment typically includes a CPU unit 100 and one or a plurality of functional units 150. In the PLC 2 according to the embodiment, the remote I/O device 3 includes a communication coupler unit 200 and one or a plurality of functional units 150.

### (b1: CPU unit 100)

The CPU unit 100 is an element constituting the control system 1 including the PLC 2, and corresponds to a computing unit that controls a process in the control system 1. The CPU unit 100 and the one or plurality of functional units 150 are connected to each other via a local network 4 which is an example of a communication line.

The CPU unit 100 includes a local master circuit 110, a remote master circuit 120, a computing processing unit 130, and a communication activation circuit 140.

The local master circuit 110 corresponds to a communication circuit that transmits and receives data to and from the one or plurality of functional units 150 (first functional units) mounted in the CPU unit 100 via a local network 4 which is an example of a communication line. More specifically, the local master circuit 110 receives data (input data) collected or generated by the one or plurality of functional units 150, and transmits data (output data) acquired or generated by the CPU unit 100 to the one or plurality of functional units 150.

The local master circuit 110 is physically connected to the local network 4, generates an electrical signal according to a command from the communication activation circuit 140, transmits a communication frame to the local network 4, receives a communication frame that is transferred on the local network 4, and outputs the received communication frame to the computing processing unit 130 via the communication activation circuit 140. In addition to exchange of data via the local network 4, the local master circuit 110 has a function of performing, for example, time management and transmission and reception timing management for guaranteeing an arrival time of a communication frame that is transferred on the local network 4.

On the local network 4, communication frames having a predetermined data structure may be sequentially transferred in a predetermined cycle, and the CPU unit 100 and each functional unit 150 write designated data to a designated area, for the sequentially transferred communication frames, and read out necessary data from the corresponding area.

In the local network 4, a type of constant periodic network may be adopted, and transmission and transfer of communication frames are repeated in a predetermined cycle under the control of the local master circuit 110 of the CPU unit 100.

As such a constant period network, a network according to a known protocol such as EtherCAT (registered trademark), EtherNet/IP (registered trademark), DeviceNet (registered trademark), or CompoNet (registered trademark) may be adopted.

More specifically, the local master circuit 110 includes a transmission and reception port 112, a transmission and reception controller 116, and a clock 118.

The transmission and reception port 112 is a part physically connected to the local network 4, generates an electrical signal according to a command from the transmission and reception controller 116, transmits the electrical signal onto the local network 4, converts an electrical signal generated on the local network 4 into a digital signal, and outputs the digital signal to the transmission and reception controller 116.

The transmission and reception controller 116 performs a process regarding generation and reception of a communication frame transferred on the local network 4.

The clock 118 generates a pulse serving as a reference for a timing at which transmission or the like of a communication frame is instructed from the transmission and reception controller 116. As the clock 118, a real-time clock can be adopted, but in the embodiment, a free run counter that counts up (increments) in a predetermined cycle may be used. A current time can be calculated by handling a counter value output by the free-run counter as an elapsed time from a certain point in time, and accordingly, the clock can be caused to function as a timer.

The remote master circuit 120 transmits and receives data to and from the one or plurality of functional units 150 (second functional units) included in the remote I/O device 3 via the remote network 5 which is an example of a communication line. More specifically, the remote master circuit 120 receives the data (input data) collected or generated by the remote I/O device 3, and transmits the data (output data) acquired or generated by the CPU unit 100 to the remote I/O device 3.

The remote master circuit 120 is physically connected to the remote network 5, generates an electrical signal according to a command from the communication activation circuit 140, transmits a communication frame onto the remote network 5, receives the communication frame transferred on the remote network 5, and outputs the received communication frame to the computing processing unit 130 via the communication activation circuit 140. In addition to the exchange of the data via the remote network 5, the remote master circuit 120 has a function of performing, for example, time management and transmission and reception timing management for guaranteeing an arrival time of a communication frame transferred on the remote network 5.

On the remote network 5, communication frames having a predetermined data structure may be sequentially transferred in a predetermined cycle, and each remote I/O device 3 writes designated data to a designated area, for the sequentially transferred communication frames, and reads out necessary data from the corresponding area.

In the remote network 5, a type of periodic network may be adopted, and transmission and transfer of communication frames are repeated in a predetermined cycle under the control of the remote master circuit 120 of the CPU unit 100.

As such a fixed period network, a network according to a known protocol such as EtherCAT (registered trademark), EtherNet/IP (registered trademark), DeviceNet (registered trademark), or CompoNet (registered trademark) may be adopted.

More specifically, the remote master circuit 120 includes a transmission and reception port 122, a transmission and reception controller 126, and a clock 128.

The transmission and reception port 122 is a part physically connected to the remote network 5, generates an electrical signal according to a command from the transmission and reception controller 126, transmits the electrical signal onto the remote network 5, converts an electrical signal generated on the remote network 5 into a digital signal, and outputs the digital signal to the transmission and reception controller 126.

The transmission and reception controller 126 performs a process regarding generation and reception of a communication frame that is transferred on the remote network 5.

The clock 128 generates a clock serving as a reference for a timing at which transmission or the like of a communication frame is instructed from the transmission and reception controller 126. As the clock 128, a real-time clock can be adopted, but in the embodiment, a free run counter that counts up (increments) in a predetermined cycle may be used.

The computing processing unit 130 includes a processor 132 and a memory 134. For convenience of description, only one processor 132 is illustrated in FIG. 1 and a plurality of processors may be mounted. It should be noted that each processor may have a plurality of cores.

The memory 134 includes a portion (typically, a volatile memory) that provides a work area necessary for execution of a program in the processor 132, and a portion (typically, a non-volatile memory) that stores a program itself to be executed by the processor 132. A dynamic random access memory (DRAM), a static random access memory (SRAM), or the like can be used as the volatile memory, and a flash memory, a hard disk, or the like can be used as the nonvolatile memory.

The memory 134 stores a system program 136, a user program 137, a configuration 138, and the like. The system program 136 includes an operating system (OS) and a library for executing the user program 137 in the processor 132. The user program 137, typically, includes an instruction for executing a computing process (for example, logical computation or numerical computation) using the data (input data) acquired from the one or plurality of functional units 150, or a process of generating data (output data) to be transmitted to the one or plurality of functional units 150, and is arbitrarily created according to a machine or facility that is a control target. The configuration 138 includes various setting values necessary for execution of the program in the CPU unit 100 or various setting values defining a network configuration.

The communication activation circuit 140 has a function of mediating a request between the computing processing unit 130 and the local master circuit 110/the remote master circuit 120. For example, the communication activation circuit 140 may request the local master circuit 110 and/or the remote master circuit 120 to transmit a communication frame including output data in response to a communication request from the processor 132. The communication activation circuit 140 includes a clock 142 and manages, for example, a transmission timing of the communication frame in the local master circuit 110 and/or the remote master circuit 120 using a clock generated by the clock 142 as a timing reference. The clock 142 functions as a master clock (a "ground master clock" to be described below) that manages a time in the control system 1.

At least main units of the communication activation circuit 140 have a hard-wired configuration, thereby realizing a faster process as compared with the processor 132. That is, the communication activation circuit 140 is realized using a hardware logic. For example, the communication activation circuit 140 is implemented using a field-programmable gate array (FPGA) which is an example of a programmable logic device (PLD), an application specific integrated circuit (ASIC) which is an example of an integrated circuit (IC), or the like.

In the configuration illustrated in FIG. 1, configurations are drawn separately for the local master circuit 110, the remote master circuit 120, the computing processing unit 130, and the communication activation circuit 140 for convenience of description, but the configuration is not limited thereto and any implementation form can be adopted. For example, a system on chip (SoC) in which all or a part of the computing processing unit 130 and the communication activation circuit 140 are mounted in the same chip may be adopted. Alternatively, the entire computing processing unit 130 may be mounted in a single chip, and the local master circuit 110, the remote master circuit 120, and the communication activation circuit 140 may be mounted in separate chips. Such implementation forms are appropriately selected in consideration of required performance, cost, or the like.

### (b2: Functional unit 150)

The functional unit 150 provides various functions necessary for realizing control of various machines or facilities in the control system 1. More specifically, each of the functional units 150 includes a functional module 156, an I/O interface 158, and a communication circuit 160.

The functional module 156 is a unit that executes a main process of each functional unit 150, and serves to collect field information from a machine or facility that is a control target and output a command signal to the machine or facility that is a control target.

The I/O interface 158 is a circuit that mediates the exchange of signals with a machine or facility that is a control target.

The communication circuit 160 processes communication frames sequentially transferred on the local network 4. That is, when the communication circuit 160 receives any communication frame via the local network 4, the communication circuit 160 writes and/or reads out data to and/or from the received communication frame and then transmits the communication frame to the functional unit 150 located subsequently on the local network 4. The communication circuit 160 provides a function of such a frame relay.

More specifically, the communication circuit 160 includes transmission and reception ports 162 and 164, a transmission and reception controller 166, and a clock 168.

The transmission and reception ports 162 and 164 are parts physically connected to the local network 4, and perform processes such as reception and reproduction of a communication frame transferred on the local network 4 according to an instruction from the transmission and reception controller 166, thereby realizing sequential transfer of communication frames.

The transmission and reception controller 166 performs data writing and/or data reading on the communication frame that is transferred on the local network 4.

The clock 168 generates a clock serving as a reference for a timing of command output in the transmission and reception controller 166, process execution in the functional module 156, or the like. As the clock 168, a real-time clock can be adopted, but in the embodiment, a free run counter that counts up (increments) in a predetermined cycle may be used.

### (b3: Communication coupler unit 200)

The communication coupler unit 200 corresponds to a relay device that exchanges data between the CPU unit 100 and the one or plurality of functional units 150. The communication coupler unit 200 and the one or plurality of functional units 150 are connected via a local network 6 which is an example of a communication line. The communication coupler unit 200 and the CPU unit 100 are connected via a remote network 5 which is an example of a communication line.

Since the local network 6 is substantially the same as the local network 4 of the CPU unit 100 described above, detailed description thereof will not be repeated herein. However, it is not necessary to adopt the same protocol for the local network 4 and the local network 6, and a protocol according to each device may be adopted.

The communication coupler unit 200 includes a local master circuit 210 and a remote slave circuit 220.

The local master circuit 210 exchanges data with the one or plurality of functional units 150 mounted in the communication coupler unit 200 via the local network 6 which is an example of a communication line. More specifically, the local master circuit 210 receives data (input data) collected or generated by the one or plurality of functional units 150, and transmits data (output data) received from the CPU unit 100 via the remote network 5, to the one or plurality of functional units 150.

The local master circuit 210 is physically connected to the local network 6, generates an electrical signal according to a command from the remote slave circuit 220, transmits a communication frame onto the local network 6, receives the communication frame transferred on the local network 6, and outputs the communication frame to the remote slave circuit 220. In addition to exchange of the data via the local network 6, the local master circuit 210 has a function of performing time management, transmission, reception timing management, and the like for guaranteeing an arrival time of the communication frame transferred on the local network 6.

More specifically, the local master circuit 210 includes a transmission and reception port 212, a transmission and reception controller 216, and a clock 218.

The transmission and reception port 212 is a part that is physically connected to the local network 6, generates an electrical signal according to a command from the transmission and reception controller 216, transmits the electrical signal to the local network 6, converts the electrical signal generated on the local network 6 into a digital signal, and outputs the digital signal to the transmission and reception controller 216.

The transmission and reception controller 216 performs a process related to generation and reception of a communication frame that is transferred on the local network 6.

The clock 218 generates a clock serving as a reference for a timing at which transmission or the like of a communication frame is instructed from the transmission and reception controller 216. As the clock 218, a real-time clock can be adopted, but in the embodiment, a free run counter that counts up (increments) in a predetermined cycle may be used.

The remote slave circuit 220 exchanges data with the CPU unit 100 or another communication coupler unit 200 via the remote network 5 which is an example of a communication line. More specifically, the remote slave circuit 220 transmits, to the CPU unit 100, the input data included in the communication frame from the functional unit 150 received by the local master circuit 210, and transmits the output data included in the communication frame received from the CPU unit 100, to the respective functional units 150 via the local master circuit 210.

The remote slave circuit 220 provides a necessary activation command to the local master circuit 210 according to content of a communication frame received over the remote network 5. The remote slave circuit 220 executes a process of managing a transmission timing of a communication frame transferred on the local network 6, in addition to the process related to the transmission and reception of a communication frame transferred on the local network 6.

More specifically, the remote slave circuit 220 includes transmission and reception ports 222 and 224, a transmission and reception controller 226, and a clock 228.

The transmission and reception ports 222 and 224 are parts physically connected to the remote network 5, and perform processes such as reception and reproduction of a communication frame transmitted on the remote network 5 according to an instruction from the transmission and reception controller 226, thereby realizing sequential transfer of communication frames.

The transmission and reception controller 226 performs data writing and/or data reading on a communication frame that is transferred on the remote network 5.

The clock 228 generates a clock serving as a reference for a timing of a process for a communication frame transferred on the remote network 5 or transmission of a communication frame transferred on the local network 6. As the clock 228, a real-time clock can be adopted, but in the embodiment, a free run counter that counts up (increments) in a predetermined cycle may be used.

It should be noted that since the functional unit 150 mounted in the communication coupler unit 200 is substantially the same as the functional unit 150 mounted in the CPU unit 100, detailed description thereof will not be repeated herein.

### <C. Transmission of output data to functional unit>

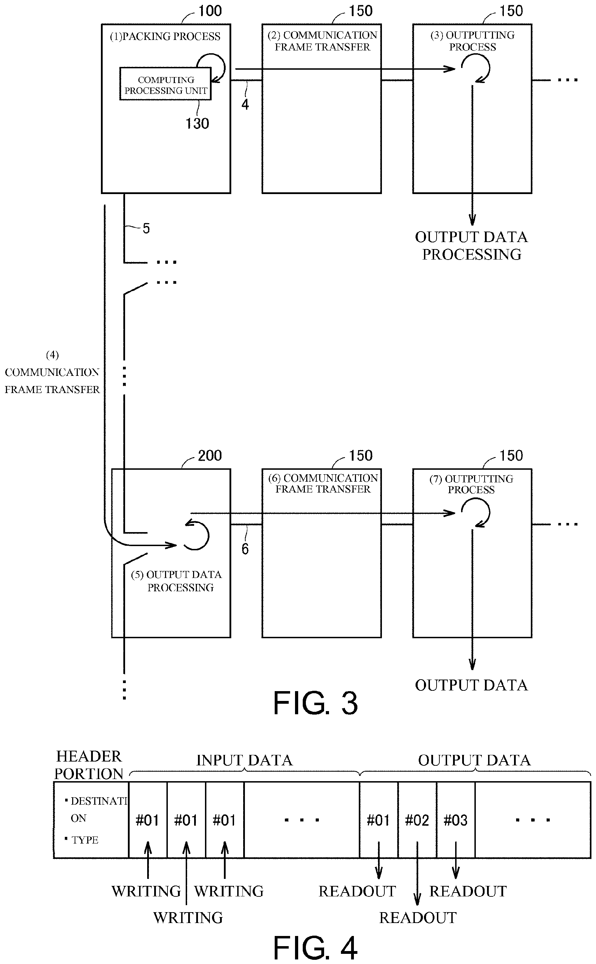

Next, a process required for transmitting output data to each functional unit 150 in the control system 1 according to the embodiment will be described. FIG. 3 is a diagram illustrating a process necessary for starting to output or updating the output signal in the control system 1 according to the embodiment.

The process for starting to output or updating an output signal from each of the functional unit 150 mounted in the CPU unit 100 and the functional unit 150 mounted in the communication coupler unit 200 will be described with reference to FIG. 3.

First, output data to be directed to each functional unit 150 is generated in the CPU unit 100 (the computing processing unit 130), and a packing process for storing the generated data in a communication frame and transmitting a resultant communication frame is executed ((1) packing process).

For output data defining the output signal from the functional unit 150 mounted in the CPU unit 100, a communication frame in which output data that is a target has been stored is transferred to the functional unit 150 that is a target via the local network 4 ((2) communication frame transfer). In the functional unit 150 that is a target, a process such as readout of necessary output data from the received communication frame is executed, and the readout output data is externally output as a real signal ((3) outputting process).

On the other hand, for output data defining an output signal from the functional unit 150 mounted in the communication coupler unit 200, a communication frame in which the output data that is a target has been stored is transferred to the communication coupler unit 200 in which the functional unit 150 that is a target has been mounted, via the remote network 5 ((4) communication frame transfer). The communication coupler unit 200 that has received the communication frame executes a process such as readout of necessary output data from the received communication frame, stores the readout output data in a new communication frame, and transmits a resultant communication frame ((5) output data processing). This new communication frame is transferred to the functional unit 150 that is a target via the local network 6 ((6) communication frame transfer). In the functional unit 150 that is a target, a process such as readout of necessary output data from the received communication frame is executed, and the readout output data is externally output as a real signal ((7) outputting process).

Thus, for the functional unit 150 mounted in the CPU unit 100, the communication frame generated by the CPU unit 100 may be directly transmitted via the local network 4, whereas for the functional unit 150 mounted in the communication coupler unit 200, it is necessary to first transmit the communication frame generated by the CPU unit 100 to the corresponding communication coupler unit 200 via the remote network 5, and then, it is necessary for the communication coupler unit 200 to generate a new communication frame and transmit the new communication frame to the functional unit 150 that is a target via the local network 6. That is, for the functional unit 150 mounted in the communication coupler unit 200, it is necessary to pass through two-stage networks, which takes more time and complicates a process in the middle, as compared with a case in which output data is transmitted to the functional unit 150 mounted in the CPU unit 100.

### <D. Example of communication frame>

Next, an example of a communication frame to be used in the control system 1 according to the embodiment will be described. In this embodiment, a communication frame for performing I/O refreshing may be used as an implementation example. The I/O refreshing has a concept including a process of updating a value of input data held by the CPU unit 100 with a latest value collected by the corresponding functional unit 150 (input refresh), and a process of reflecting a value of output data calculated by the CPU unit 100 as an output value of the corresponding functional unit 150 (output refreshing).

An I/O refreshing frame is adopted as such a communication frame. The I/O refreshing frame is configured to be able to store both input data necessary for input refreshing and output data necessary for output refreshing. It should be noted that the I/O refreshing frame may be implemented so that the input refreshing and the output refreshing are separately executed. In this case, a communication frame configured to store only one of the input data and the output data is adopted.

FIG. 4 is a schematic diagram illustrating an example of a data structure of the I/O refreshing frame that is used in the control system 1 according to the embodiment. Referring to FIG. 4, the I/O refreshing frame includes a header portion for storing a frame type, a destination, and the like, and a main body portion for storing data.

As a frame type stored in the header portion, identification information for specifying a type of the communication frame may be used. For example, identification information indicating which of unicast, multicast, or broadcast the type of the communication frame is may be used. As the destination, for example, identification information of the functional unit 150 or the communication coupler unit 200 that is a transmission destination may be used.

An input data area and an output data area are defined in the main body portion, and the respective areas are associated with all or some of the functional units 150 or the communication coupler units 200 in a transfer path for the I/O refreshing frame.

When each of the functional unit 150 and the communication coupler unit 200 receives the I/O refreshing frame, each of the functional unit 150 and the communication coupler unit 200 reads out the output data stored in an area assigned to the own unit and also writes the input data collected or generated by the own unit to an area assigned to the own unit. The I/O refreshing can be realized by the readout of the output data and writing of the input data being executed in each unit.

Although FIG. 4 illustrates the example of the data structure in which the input data from the one or plurality of functional units 150 or the communication coupler unit 200 and the output data to the one or plurality of functional units 150 or the communication coupler units 200 are stored in a single communication frame, a communication frame in which only one of the input data and the output data is stored may be adopted. In this case, for example, each of a communication frame for input data and a communication frame for output data may be prepared. Further, the input data and the output data that are targets of the I/O refreshing are configured in advance, and not all of pieces of data collected by the functional units 150 are transmitted to the CPU unit 100.

### <E. Processing timing of each unit in control system>

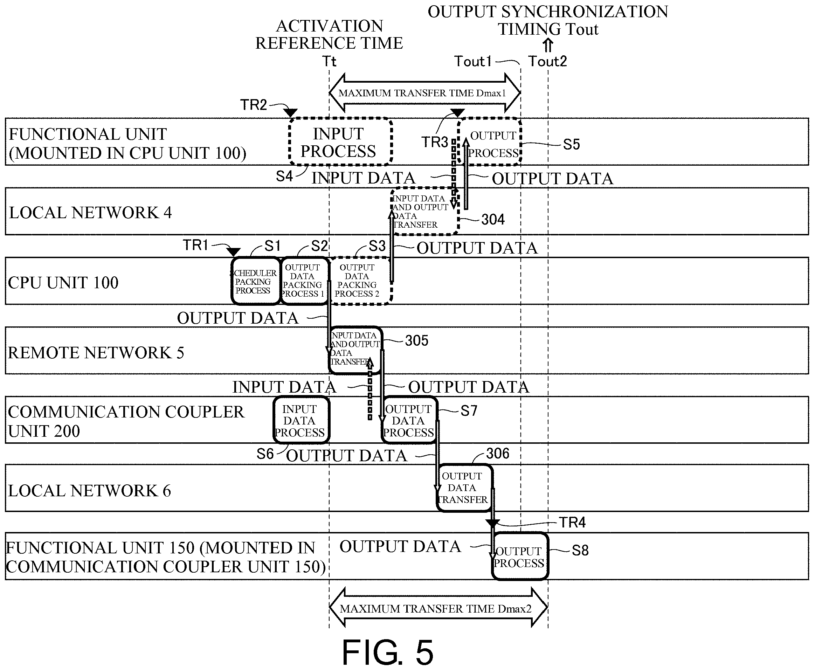

Next, a processing timing related to the output timing synchronization function that is provided by the control system 1 according to the embodiment will be described. FIG. 5 is a timing chart illustrating a process of each unit related to the output timing synchronization function that is provided by the control system 1 according to the embodiment. FIG. 5 mainly illustrates a process regarding output refreshing.

Referring to FIG. 5, the CPU unit 100 (the processor 132 of computing processing unit 130) sequentially executes preprocessing for transmitting output data generated due to execution of an I/O refreshing process
(step S1: scheduler packing process), preprocessing for storing the output data in the communication frame transmitted by the remote network 5 (step S2: output data packing process 1), and preprocessing for storing the output data in the communication frame transmitted by the local network 4 (step S3: output data packing process 2). The three packing processes correspond to (1) packing process illustrated in FIG. 3.

Further, an activation command is given to the local master circuit 110 (FIG. 2) at a timing at which the execution of the output data packing process 2 is completed (step S3), and the communication frame 304 which is an I/O refreshing frame is transferred to the local network 4.

Each of the functional units 150 connected to the local network 4 executes an input process including, for example, collection of input data to be transmitted to the CPU unit 100 (step S4), in advance before arrival of the communication frames 304 that are sequentially transferred on the local network 4. When the functional units 150 receives the communication frame 304, the functional units 150 writes input data prepared in advance to the received communication frame 304 and reads out output data addressed to the functional unit from the received communication frame 304. Each of the functional units 150 executes an outputting process including a process of externally outputting a signal corresponding to the readout output data (step S5).

Further, an activation command is given to the remote master circuit 120 (FIG. 2) at a timing at which the execution of the output data packing process 1 is completed (step S2), and the communication frame 305 which is an I/O refreshing frame is transferred to the remote network 5. A timing at which the communication frame 305 is transmitted is referred to as an "activation reference time Tt". The communication frame 305 is sequentially transferred on the remote network 5.

The communication coupler unit 200 executes input data processing (step S6) including, for example, collection of input data to be transmitted to the CPU unit 100, in advance before arrival of the communication frames 305 that are sequentially transferred on the remote network 5. When the communication coupler unit 200 receives the communication frame 305, the communication coupler unit 200 writes input data prepared in advance to the received communication frame 305 and reads out output data addressed to the communication coupler unit from the received communication frame 305.

Subsequently, an activation command is given to the local master circuit 210 (FIG. 2), and a communication frame 306 including the output data is transmitted to the local network 6. When each of the functional units 150 connected to the local network 6 receives the communication frame 306 sequentially transferred on the local network 6, the functional unit 150 reads out the output data addressed to the functional unit from the received communication frame 306. Each of the functional units 150 executes an outputting process including a process of externally outputting a signal corresponding to the readout output data (step S8).

In the time chart illustrated in FIG. 5, a timing at which the output data becomes able to be output from the functional unit 150 mounted in the CPU unit 100 is a time Tout1. The time Tout1 may change depending on a position at which each functional unit 150 is connected, and performance of each functional unit 150. Therefore, in the embodiment, a delay time from designation in the CPU unit 100 for transmission of a communication frame to each functional unit 150 mounted in the CPU unit 100 to a time when the output data included in the communication frame becomes able to be output is calculated, and a maximum one (a maximum delay time Dmax1) of the calculated delay times is determined.

Similarly, a timing at which the output data becomes able to be output from the functional unit 150 mounted in the communication coupler unit 200 is a time Tout2. The time Tout2 may change depending on a position on a network topology at which each functional unit 150 is connected, and performance of each functional unit 150. Therefore, in the embodiment, a delay time from designation in the CPU unit 100 for transmission of a communication frame to each functional unit 150 mounted in the communication coupler unit 200 to a time when the output data included in the communication frame becomes able to be output is calculated, and a maximum one (a maximum delay time Dmax2) of the calculated delay times is determined.

Further, a time corresponding to the longer one of the maximum delay time Dmax1 and the maximum delay time Dmax2 is determined as an output synchronization timing Tout for the entire control system 1. Typically, a time obtained by adding which the maximum delay time Dmax1 or the maximum delay time Dmax2 to the activation reference time Tt is the output synchronization timing Tout.

As an example, FIG. 5 illustrates an example of the maximum delay time Dmax1 < the maximum delay time Dmax2. In this example, the time Tout2 may be set as the output synchronization timing Tout.

Thus, in the embodiment, a maximum delay time required up to a time at which the signal corresponding to the output data becomes able to be output to each functional unit 150 after a request for transmission of the output data is made from the CPU unit 100 is calculated, and the output synchronization timing is determined in consideration of the maximum delay time of the entire system. By setting a timing according to the output synchronization timing for the synchronized clocks held by the respective units, signals corresponding to the output data are simultaneously externally output from the respective functional units 150.

Hereinafter, a method of calculating the maximum delay time and the output synchronization timing will be described, and a method of setting clock synchronization and output synchronization timings will be described.

### <F. Method of calculating maximum delay time and output synchronization timing>

Next, a method of calculating the maximum delay time and the output synchronization timing will be described.

For example, the maximum delay time Dmax2 for each functional unit 150 mounted in the communication coupler unit 200 is determined depending on the position on the network topology at which each functional unit 150 is connected and the performance of each functional unit 150 itself. Typically, at least some of the following time elements (1) to (5) are considered to calculate the maximum delay time.

(1) Time required until a communication frame including the output data is transmitted onto the remote network 5 after an output data transmission command (an activation command) is given to the remote master circuit 120 of the CPU unit 100 (remote master circuit activation delay time).
(2) Time required until a communication frame including the output data transmitted on the remote network 5 is transferred from the remote master circuit 120 to the communication coupler unit 200 that is a target (remote network transfer delay time).
(3) Time until the communication frame including the output data received by the communication coupler unit 200 is received and processed, and a separate communication frame including the output data is transmitted onto the local network 6 (communication coupler processing time).
(4) Time required until a communication frame including output data transferred on the local network 6 is transferred from the communication coupler unit 200 to the functional unit 150 that is a target (local network transfer delay time).
(5) Time required until a signal corresponding to the received data becomes able to output from the functional unit 150 after each functional unit 150 receives a communication frame including output data (functional unit processing time).

A sum of the time elements (1) to (5) described above (a delay time of each functional unit 150) is calculated for each of the functional units 150 included in the control system 1. A maximum one of these delay times is determined as the maximum delay time Dmax2.

Thus, a maximum time (the maximum delay time Dmax2) required until the signal corresponding to the output data becomes able to be output in each functional unit 150, when viewed from the CPU unit 100 (the remote master circuit 120), is calculated. The maximum delay time Dmax2 may be calculated as an elapsed time (an offset time) from the time (the activation reference time Tt in FIG. 5) at which the activation command is given to the remote master circuit 120.

It should be noted that it is not always necessary to consider that an order greatly differs between the time elements (1) to (5) described above. For example, when the remote master circuit activation delay time is small enough to be neglected as compared with the transfer delay time of the communication frame, the remote master circuit activation delay time may be set to a predetermined constant value or may be not taken into consideration.

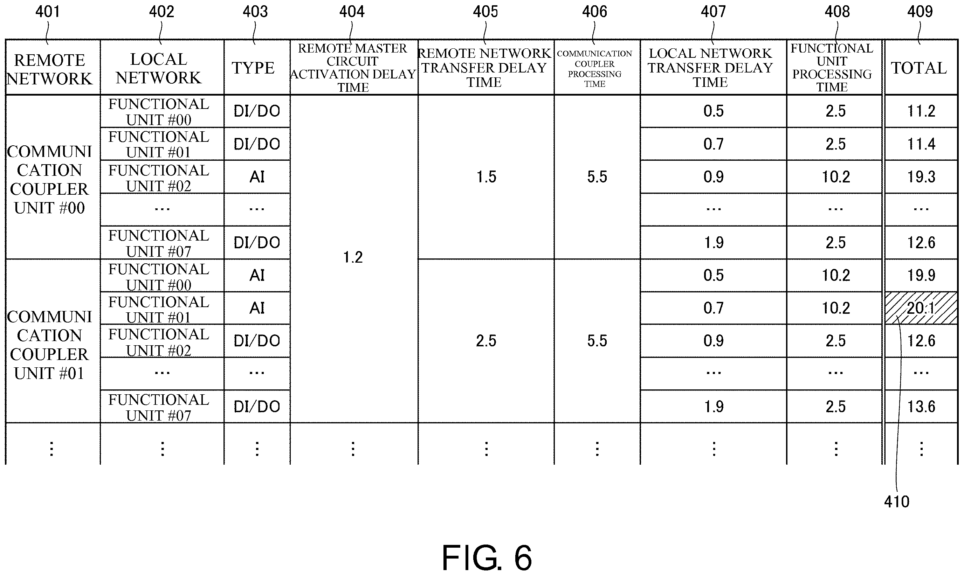

FIG. 6 is a diagram illustrating a procedure of calculating the maximum delay time Dmax2 related to the output timing synchronization function that is provided by the control system 1 according to the embodiment. In FIG. 6, an example of calculation results is shown in such a table format for convenience of description, and it is not necessary to visualize such a table format and the calculation results may be implemented as an internal process.

Referring to FIG. 6, each communication coupler unit 200 connected to remote network 5 is set in a list format (column 401). Each functional unit 150 mounted in each of the communication coupler units 200 is set in a list format (column 402). Further, a type of each functional unit 150 is also set (column 403). Generally, these pieces of information are set in advance as part of the configuration 138 (FIG. 2). Alternatively, the information may be acquired by referring to the configuration stored in the support device for developing or maintaining the program to be executed by the CPU unit 100.

Respective times of a remote master circuit activation delay time 404, a remote network transfer delay time 405, a communication coupler processing time 406, a local network transfer delay time 407, and a functional unit processing time 408 are set in association with each of the functional units 150.

The remote master circuit activation delay time 404 is generally performance unique to the remote master circuit 120 of the CPU unit 100. Therefore, it is possible to prepare a database for the remote master circuit activation delay time 404 defined for each piece of identification information (a format number or the like) of the CPU unit 100 in advance and acquire the remote master circuit activation delay time 404 by referring to this database.

The remote network transfer delay time 405, generally, depends on the number of nodes/number of hops present on the path of the remote network 5 from the CPU unit 100 (the remote master circuit 120), a path length (that is, a cable length) of the remote network 5 from the CPU unit 100 (the remote master circuit 120), or the like. For example, the remote network transfer delay time 405 which is longer than that of the communication coupler unit 200 disposed at a position near the CPU unit 100 is generated in the communication coupler unit 200 disposed at a position far from the CPU unit 100. Therefore, the value of the remote network transfer delay time 405 is calculated in consideration of, for example, a connection state (a network topology) of the communication coupler unit 200 in the remote network 5. When the value of the remote network transfer delay time 405 is calculated, a functional equation including parameters regarding the network topology may be adopted. Alternatively, an actually measured time required for transfer of a communication frame in the remote network 5 may be used.

The communication coupler processing time 406 is generally is performance unique to the local master circuit 210 and the remote slave circuit 220 of the communication coupler unit 200. Therefore, it is possible to prepare a database for the communication coupler processing time 406 defined for each piece of identification information (a format number or the like) of the communication coupler unit 200 in advance and acquire the communication coupler processing time 406 by referring to this database.

The local network transfer delay time 407, generally, depends on the number of nodes/number of hops present on the path of the local network 6 from the communication coupler unit 200 (the remote slave circuit 220), or the like. For example, the local network transfer delay time 407 which is longer than that of the functional unit 150 disposed at a position near the communication coupler unit 200 is generated in the functional unit 150 disposed at a position far from the communication coupler unit 200. Therefore, the value of the local network transfer delay time 407 is calculated in consideration of, for example, a connection state (a network topology) of the functional unit 150 in the local network 6. When the value of the local network transfer delay time 407 is calculated, a functional equation including parameters regarding the network topology may be adopted. Alternatively, an actually measured time required for transfer of a communication frame in the local network 6 may be used.

The functional unit processing time 408 depends on a function provided by each functional unit 150 or the like. In general, an analog output (AO) unit requires a lot of time until the signal corresponding to the output data can be actually output after the output data is given, as compared with the digital output (DO) unit. Generally, the functional unit processing time 408 is performance specific to each functional unit 150. Therefore, it is possible to prepare a database for the functional unit processing time 408 defined for each piece of identification information (a format number or the like) of the functional unit 150 in advance and acquire the functional unit processing time 408 by referring to this database.

A sum indicating the delay time of each functional unit 150 included in the control system 1 can be calculated by considering the respective time elements as described above (column 409). Among these delay times, the delay time having the greatest value (total 410 in FIG. 6) is determined as the maximum delay time Dmax2.

Further, for the maximum delay time Dmax1 for each functional unit 150 mounted in the CPU unit 100, at least some of the following time elements (6) to (8) are typically taken into account.
(6) Time required until a communication frame including the output data is transmitted on the local network 4 after an output data transmission command (activation command) is given to the local master circuit 110 of the CPU unit 100 (local master circuit activation delay time).
(7) Time required for transfer of the communication frame including output data transferred on the local network 4 from the CPU unit 100 to the functional unit 150 that is a target (a local network transfer delay time).
(8) Time required until a signal corresponding to the received data becomes able to be output from the functional unit 150 after each functional unit 150 receives the communication frame including the output data (functional unit processing time).

A sum of the time elements (6) to (8) (a delay time of each functional unit 150) is calculated for each of the functional units 150 included in the control system 1. A maximum one of these delay times is determined as the maximum delay time Dmax1.

Since the time elements (6) to (8) have the same content as the time elements (1), (4), and (5) described above, respectively, detailed description thereof will not be repeated.

Thus, a maximum time (the maximum delay time Dmax1) required until the signal corresponding to the output data becomes able to be output in each functional unit 150, when viewed from the CPU unit 100 (the local master circuit 110), is calculated. The maximum delay time Dmax1 may be calculated as an elapsed time (an offset time) from the time (the activation reference time Tt in FIG. 5) at which the activation command is given to the remote master circuit 120.

For the transfer delay times (2), (4), and (7) among the time elements described above, a time up to a unit (a slave unit) located farthest from the CPU unit 100 or the communication coupler unit 200 (a worst value) may be uniformly adopted. By adopting such a worst value, it is possible to calculate the maximum delay time with a certain margin. When communication frames are sequentially transferred among a plurality of units connected to the network, the delay time may be determined on the basis of, for example, the count value of a clock written to the communication frame by a unit last involving in the transfer of the communication frame and held by each unit. In such a case, it is unnecessary to create a database in advance, and the transfer delay time is determined on the basis of an actual measured values.

When each functional unit 150 holds information on performance or the like of the functional unit, the CPU unit 100 may read out the information and calculate the maximum delay time of each functional unit 150. The information held by each functional unit 150 may include a value actually measured at the time of factory shipment or may include a log or the like according to an operation. By reflecting these pieces of information, the maximum delay time can be calculated with higher accuracy.

### <G. Method of setting clock synchronization and output synchronization timings>

Next, a method of setting clock synchronization and output synchronization timings will be described.

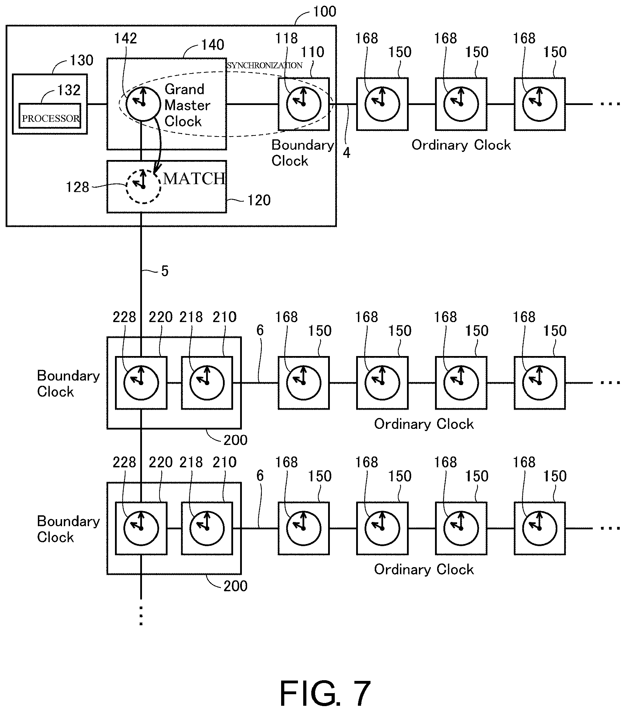

FIG. 7 is a schematic diagram focusing on the clocks disposed in a distributive manner in the control system 1 according to the embodiment. Referring to FIG. 7, in the control system 1 according to the embodiment, synchronization between clocks disposed in the respective units is maintained in three layers of a ground master clock, a boundary clock, and an ordinary clock.

For example, in a network conforming to EtherCAT (registered trademark), times can be synchronized with high accuracy among slaves (the functional units 150) using a distributed clock function. Further, by adopting an arbitrary PTP (Precision Time Protocol), times can be synchronized with high precision among a plurality of devices or units. Since a method of adopting such a hierarchical configuration to synchronize the times with each other is well known, detailed description thereof will not be repeated herein.

The CPU unit 100 includes the clock 142 of the communication activation circuit 140, the clock 118 of the local master circuit 110, and the clock 128 of the remote master circuit 120. In the embodiment, the clock 142 of the communication activation circuit 140 functions as a ground master clock serving as a time reference of the control system 1, and the clock 118 of the local master circuit 110 functions as a boundary clock that is synchronized with the ground master clock.

Each of the clocks 168 included in the functional units 150 connected to the local master circuit 110 can be caused to function as an ordinary clock. That is, the respective functional units 150 mounted in the CPU unit 100 synchronize time with reference to the clock 118 of the local master circuit 110. The clock 118 of the local master circuit 110 is synchronized in time with the clock 142 of the communication activation circuit 140 which is the ground master clock. Therefore, the functional unit 150 (the first functional unit) mounted in the CPU unit 100 has the clock 168 (the first clock) synchronized with the clock 142 that is a ground master clock.

On the other hand, the clock 128 of the remote master circuit 120 is configured to be substantially the same as the clock 142 of the communication activation circuit 140, and functions as a virtual ground master clock. By adopting such a configuration, in each of the communication coupler units 200 connected to the CPU unit 100, the clock 228 of the remote slave circuit 220 functions as a boundary clock. In each communication coupler unit 200, the clock 218 of the local master circuit 210 also functions as a boundary clock in synchronization with the clock 228 of the remote slave circuit 220. Each of the clocks 168 included in the functional units 150 connected to the local master circuit 210 can be caused to function as an ordinary clock.

Thus, the functional unit 150 (the second functional unit) mounted in the communication coupler unit 200 has the clock 168 (the second clock) synchronized with the clock 142 that is a ground master clock.

With the hierarchical configuration as described above, it is possible to synchronize the clocks held by the CPU unit 100, the communication coupler unit 200, and the functional units 150. That is, in any unit, various controls and actions can be executed according to a common clock. Under such an environment, the activation reference time Tt set at each predetermined cycle and the output synchronization timing Tout set on the basis of the activation reference time Tt are designated for each unit, and each unit executes a designated process at a designated timing.

As described above, the output synchronization timing Tout for the entire control system 1 is determined according to the longer one of the maximum delay time Dmax1 and the maximum delay time Dmax2. However, from the viewpoint of maintaining a task cycle, the output synchronization timing Tout for the entire control system 1 may be determined according to the shorter one of the maximum delay time Dmax1 and the maximum delay time Dmax2. At the determined output synchronization timing Tout, the CPU unit 100 and each functional unit 150 are notified of a necessary timing so that the signal corresponding to the output data is externally output from each functional unit 150.

The timing of which the CPU unit 100 and each functional unit 150 are notified will be described with reference to FIG. 5 again. It should be noted that a designated timing may be notified of in the form of a count value or a clock value.

For example, a start timing TR1 at which start of execution of the packing process (a scheduler packing process, an output data packing process 1, and an output data packing process 2) is triggered is set for the CPU unit 100.

Further, a start timing TR3 at which start of execution of an outputting process is triggered is set for the functional unit 150 mounted in the CPU unit 100. Thus, the start timing TR3 (a first timing) at which the process (outputting process) of outputting the signal corresponding to the output data received by the functional unit 150 (the first functional unit) mounted in the CPU unit 100 is to be started is instructed. It should be noted that a start timing TR2 at which start of execution of the input process is triggered may be further set for the functional unit 150 mounted in the CPU unit 100.

On the other hand, a start timing TR4 at which start of execution of the outputting process is triggered is set for the functional unit 150 mounted in the communication coupler unit 200. Thus, the start timing TR4 (a second timing) at which the process (outputting process) of outputting the signal corresponding to the output data received by the functional unit 150 (the second functional unit) mounted in the communication coupler unit 200 is to be started is instructed. It should be noted that a start timing at which start of execution of the input process (not illustrated) is triggered may be further set for the functional unit 150 mounted in the communication coupler unit 200.

By setting the necessary start timings in the CPU unit 100 and the functional unit 150, the output timing synchronization function according to the embodiment is realized. That is, timings at which the signal corresponding to the output data is externally output or updated can be synchronized with each other among the functional units 150 included in the control system 1.

The calculation and setting of the output synchronization timing as described above may be realized by one or a plurality of any calculation subjects. Typically, a logic for calculating and setting the output synchronization timing may be implemented in the CPU unit 100, or a function for calculating and setting the output synchronization timing may be implemented in the support device.

In any of the implementations, the CPU unit 100 instructs the start timing TR3 (first timing) or the start timing TR4 (second timing) to each functional unit 150. As is obvious from the time chart illustrated in FIG. 5, and the like, these start timings TR3 and TR4 are set with reference to a time (for example, the activation reference time Tt) managed by the clock 142 that is a ground master clock of the CPU unit 100. This is because each of the functional units 150 included in the control system 1 performs time synchronization directly or indirectly with the clock 142 which is the ground master clock.

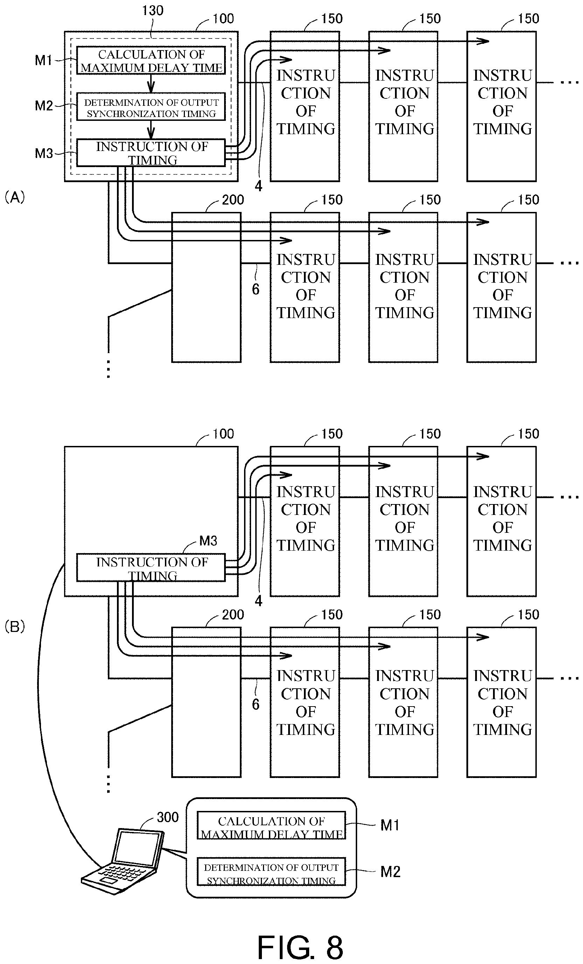

FIG. 8 is a schematic diagram illustrating a configuration example for setting the output synchronization timing in the control system 1 according to the embodiment. FIG. 8(A) illustrates a configuration example in which a logic for calculating and setting the output synchronization timing is implemented in the CPU unit 100. FIG. 8(B) illustrates a configuration example in which the support device has a function of calculating and setting the output synchronization timing.

A function M1 of calculating a maximum delay time, a function M2 of determining the output synchronization timing, and a function M3 of instructing a timing according to the determined output synchronization timing are implemented in the computing processing unit 130 of the CPU unit 100 illustrated in FIG. 8(A). These functions may be realized by instruction code included in the system program 136 (FIG. 2). That is, these functions M1 to M3 may be realized by the processor 132 of the computing processing unit 130 executing the system program 136.

As described above, the function of determining parameters such as a timing required for the output timing synchronization function according to the embodiment is not necessarily implemented in the control system 1 and may be set from an external device such as the support device 300.

The function M1 of calculating the maximum delay time includes, more specifically, a function of calculating a delay time required until the signal corresponding to the output data becomes able to be output in the CPU unit 100 that is a transmission destination after transmission of the output data to the local master circuit 110 is requested in the CPU unit 100 (a maximum one of the delay times is the maximum delay time Dmax1), and a delay time required until the signal corresponding to the output data becomes able to be output in the functional unit 150 that is a transmission destination after transmission of the output data to the remote master circuit 120 is requested in the CPU unit 100 (a maximum one of the delay times is the maximum delay time Dmax2).

The function M2 of determining the output synchronization timing includes, more specifically, a function of determining the output synchronization timing Tout at which the functional unit 150 included in the control system 1 outputs a signal on the basis of the maximum delay time Dmax1 and the maximum delay time Dmax2. The function M2 of determining the output synchronization timing determines the start timing TR3 (a first timing) at which the outputting process is to be started in the functional unit 150 (the first functional unit) mounted in the CPU unit 100 and the start timing TR4 (a second timing) at which the outputting process is to be started in the functional unit 150 (the second functional unit) mounted in the communication coupler unit 200 on the basis of the determined output synchronization timing Tout (see FIG. 5).

In FIG. 8(B), a function M1 of calculating the maximum delay time and a function M2 of determining the output synchronization timing are mounted in the support device 300 connected to the CPU unit 100. These functions M1 and M2 may be provided by a support program that is executed in the support device 300. On the other hand, it is preferable for the function M3 of instructing the timing according to the determined output synchronization timing to be mounted in the CPU unit 100.

As illustrated in FIG. 8(B), when the timing is calculated by the support device 300, the function M3 acquires a start timing TR3 (a first timing) at which an outputting process is to be started in the functional unit 150 (a first functional unit) mounted in the CPU unit 100 and a start timing TR4 (a second timing) at which an outputting process is to be started in the functional unit 150 (a second functional unit) mounted in the communication coupler unit 200, from the support device 300 (an external device) connected to the CPU unit 100.

However, the function M3 of instructing the timing according to the determined output synchronization timing may also be mounted in the support device 300. In this case, the support device 300 directly sets the timing for each functional unit 150. In such a case, the CPU unit 100 or the communication coupler unit 200 assists in a setting process.

### <H. Processing procedure>

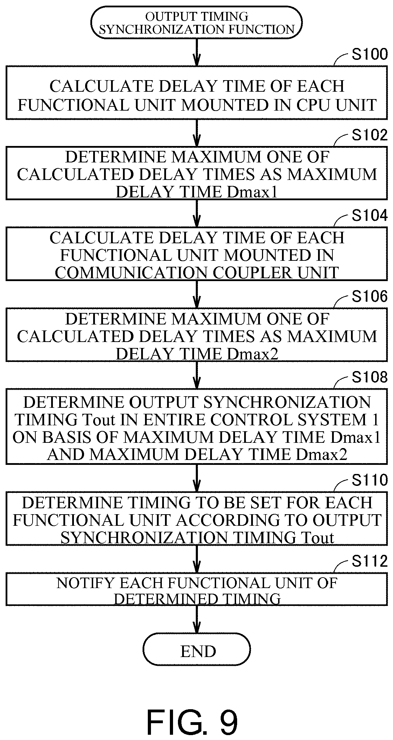

Next, a processing procedure of the output timing synchronization function according to the embodiment will be described. FIG. 9 is a flowchart illustrating a processing procedure related to the output timing synchronization function in the control system 1 according to the embodiment. In FIG. 9, an example in which each step is executed by the processor 132 of the CPU unit 100 executing the system program 136 will be described as a typical example. However, all or some of the following steps may be executed by another unit, a support device, or the like.

Referring to FIG. 9, the processor 132 calculates a delay time of each functional unit 150 mounted in the CPU unit 100, for example, by referring to the configuration 138 stored in the memory 134 (step S100), and determines a maximum one of the calculated delay times as the maximum delay time Dmax1 (step S102). Similarly, the processor 132 calculates a delay time of each functional unit 150 mounted in the communication coupler unit 200, for example, by referring to the configuration 138 stored in the memory 134 (step S104), and determines a maximum one of the calculated delay times as the maximum delay time Dmax2 (step S106).

The processor 132 determines the output synchronization timing Tout in the entire control system 1 on the basis of the maximum delay time Dmax1 determined in step S102 and the maximum delay time Dmax2 determined in step S106 (step S108).

The processor 132 determines a timing to be set for each functional unit 150 according to the output synchronization timing Tout determined in step S108 (step S110), and notifies each functional unit 150 of the determined timing (step S112). Each functional unit 150 sets a necessary timing according to a notification from the CPU unit 100.

With the above process, a setting required for the output timing synchronization function is completed. Each unit constituting the control system 1 repeats the process according to the set timing.

### <I. Modification example>

Although the control system 1 including the functional units 150 connected via the local network 4 and the functional units 150 connected via the remote network 5 and the local network 6 has been described as an application example of the output timing synchronization function in the above embodiment, the present invention is also applicable to a configuration including functional units 150 connected via another network. That is, the output timing synchronization function according to the embodiment can also be applied to a configuration including three or more different networks.

### <J. Advantages>

In the control system 1 according to the embodiment, even when there are functional units 150 that communicate with the CPU unit 100 via different communication lines (networks or buses), it is possible to synchronize the timings at which the signals are output or the timings at which the signals are updated between the plurality of functional units 150 using synchronized times as long as time synchronization can be made via the respective communication lines (networks or buses). Thus, according to the embodiment, it is possible to realize output synchronization for the plurality of functional units 150 between different networks or buses that can be synchronized with each other.

It should be considered that the embodiment disclosed this time is an example in all respects and is not restrictive. The scope of the present invention is indicated by the claims rather than the above description, and is intended to include all modifications within meaning and scope equivalent to the claims.

### [Reference Signs List]

- 1: Control system
- 2: PLC
- 3: Remote I/O device
- 4, 6: Local network
- 5: Remote network
- 100: CPU unit
- 150: Functional unit
- 110, 210: Local master circuit
- 112, 122, 162, 164, 212, 222, 224: Transmission and reception port
- 116, 126, 166, 216, 226: Transmission and reception controller
- 118, 128, 142, 168, 218, 228: Clock
- 120: Remote master circuit
- 130: Computing processing unit
- 132: Processor
- 134: Memory
- 136: System program
- 137: User program
- 138: Configuration
- 140: Communication activation circuit
- 156: Functional module
- 158: I/O Interface
- 160: Communication circuit
- 200: Communication coupler unit
- 220: Remote slave circuit
- 300: Support device
- 304, 305, 306: Communication frame
- Dmax1, Dmax2: Maximum delay time
- M1, M2, M3: Function
- OUT1, OUT2, OUT3: Output signal

## Claims

1. A computing device constituting a control system, the computing device comprising:
a master clock that manages a time in the control system;
a first communication circuit that transmits and receives data to and from a first functional unit via a first communication line, the first functional unit including a first clock synchronized with the master clock;
a second communication circuit that transmits and receives data to and from a second functional unit via a second communication line, the second functional unit including a second clock synchronized with the master clock; and
a timing instructing unit that instructs, to the first functional unit, a first timing at which a process of outputting a signal corresponding to output data received in the first functional unit is to be started, and instructs, to the second functional unit, a second timing at which a process of outputting a signal corresponding to output data received in the second functional unit is to be started, the first and second timings being defined with reference to the time that is managed by the master clock.

2. The computing device according to claim 1, further comprising:
a calculation unit that calculates a first delay time required until a signal corresponding to output data becomes able to be output in the first functional unit after transmission of the output data to the first communication circuit is requested, and a second delay time required until a signal corresponding to output data becomes able to be output in the second functional unit after transmission of the output data to the second communication circuit is requested.

3. The computing device according to claim 2, further comprising:
a synchronization timing determination unit that determines a synchronization timing at which a functional unit included in the control system outputs a signal on the basis of a maximum value of the first delay time and a maximum value of the second delay time,
wherein the synchronization timing determination unit determines the first and second timings on the basis of the determined synchronization timing.

4. The computing device according to any one of claims 1 to 3,
wherein the calculation unit calculates the first delay time and the second delay time in consideration of at least some of
a time required until data is transmitted onto the first communication line after transmission of output data to the first communication circuit is requested,
a time required until data is transmitted onto the second communication line after transmission of output data to the second communication circuit is requested,
a time required until the data transmitted onto the first communication line is transferred to the first functional unit,
a time required until the data transmitted onto the second communication line is transferred to the second functional unit,
a time required until a signal corresponding to received data becomes able to be output after the first functional unit receives the output data, and
a time required until a signal corresponding to received data becomes able to be output after the second functional unit receives the output data.

5. The computing device according to claim 1, wherein the timing instructing unit acquires the first timing and the second timing from an external device connected to the computing device.

6. The computing device according to any one of claims 1 to 5, further comprising:
a processor that executes a program; and
a communication activation circuit that is connected to the processor and requests transmission of output data to the first communication circuit and the second communication circuit.

7. The computing device according to claim 6, wherein the communication activation circuit is implemented using a field-programmable gate array (FPGA) or an application specific integrated circuit (ASIC).

8. A control system comprising:
a computing device including a master clock that manages a time in the control system;
a first functional unit that is connected to the computing device via a first communication line, the first functional unit including a first clock synchronized with the master clock;
a relay device that is connected to the computing device via a second communication line; and
a second functional unit that is connected to the relay device via a third communication line, the second functional unit including a second clock synchronized with the master clock,
wherein the computing device includes a timing instructing unit that instructs, to the first functional unit, a first timing at which a process of outputting a signal corresponding to output data received in the first functional unit is to be started, and instructs, to the second functional unit, a second timing at which a process of outputting a signal corresponding to output data received in the second functional unit is to be started, the first and second timings being defined with reference to the time that is managed by the master clock.
